# FASCICULE DE BREVET EUROPEEN

(11) **EP 1 671 371 B1**
(45) Date de publication et mention de la délivrance du brevet: **13.08.2008**
(21) Numéro de dépôt: 04741893.4
(22) Date de dépôt: 25.06.2004
(51) Int. Cl.: H01L 27/146, H01L 29/768

(54) **CAPTEUR D IMAGE ERGONOMIQUE**
ERGONOMISCHE BILDAUFNAHMEVORRICHTUNG
ERGONOMIC IMAGE RECORDER

(30) Priorité: 01.07.2003 FR 0307978
(43) Date de publication de la demande: 21.06.2006
(73) Titulaire: E2V Semiconductors, 38120 Saint Egreve (FR)
(72) Inventeur: CAUPAIN, Jean-Marie, Thales Intellectual Property, F-94117 Arcueil (FR); BEAL, Gérard, Thales Intellectual Property, F-94117 Arcueil (FR); LIGOZAT, Thierry, Thales Intellectual Property, F-94117 Arcueil (FR)
(74) Mandataire: Guérin, Michel
(86) Numéro de dépôt international: PCT/EP2004/051242
(87) Numéro de publication internationale: WO 2005/004239

(56) Documents cités:
- EP-A- 0 729 269
- WO-A-00/79598
- US-A- 5 291 010
- US-A1- 2002 100 922

## Description

L'invention concerne les capteurs d'images de petites dimensions.

L'application plus particulièrement visée ici est la prise d'image à l'intérieur du corps humain, qui nécessite de tels capteurs. On a besoin notamment de capteurs radiologiques dentaires qui sont introduits dans la bouche d'un patient pour permettre l'observation radiologique de sa machoire et sa dentition. L'ergonomie d'utilisation et le confort du patient sont des éléments très importants à prendre en compte dans la réalisation de ces capteurs.

Le capteur d'image est un capteur électronique à structure matricielle, constitué par un réseau de lignes et de colonnes avec un point photosensible au croisement de chaque ligne et chaque colonne. Des circuits électroniques sont prévus sur les côtés de la matrice pour assurer son fonctionnement, et notamment des registres latéraux de commande des conducteurs de ligne et un registre au bas des colonnes pour assurer la lecture des signaux détectés par les circuits individuels. Dans le cas d'un capteur radiologique, le réseau est recouvert d'un scintillateur pour convertir des rayons X en lumière et l'image lumineuse qui en résulte est détectée par le réseau de points photosensibles. Le document US 2002/100922 A décrit un capteur d'image comprenant une matrice de points photosensibles réalisée sur une puce.

La structure matricielle du capteur d'image est en général réalisée sur une puce semiconductrice de forme carrée ou rectangulaire comme on le fait pour presque tous les circuits intégrés. Toutefois, pour améliorer l'ergonomie, on a déjà proposé de réaliser le capteur sur une puce à coins coupés. Après encapsulation de la puce dans un boîtier de protection qui épouse la forme de la puce et arrondit les angles, le capteur a une forme plus confortable pour le patient que si la puce était rectangulaire.

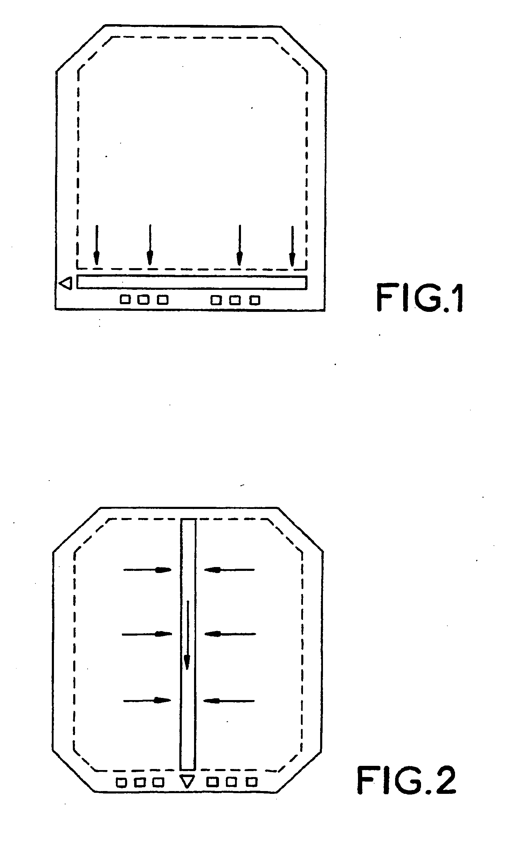

La figure 1 représente une puce dont deux coins sont coupés ; ce sont les coins situés "en haut" sur la figure, en principe à l'avant du capteur dans le sens d'introduction du capteur dans la bouche du patient. Les signaux détectés par la matrice sont déversés verticalement de la matrice vers un registre de lecture horizontal situé en bas de la matrice, donc ici du côté arrière dans le sens d'introduction du capteur, là où il n'y a pas de coins coupés. Puis les charges sont déversées horizontalement par le registre horizontal vers une sortie de ce registre. Cette solution est efficace pour le confort lors de l'introduction du capteur dans la bouche ; elle l'est moins pour le confort lors du retrait du capteur hors de la bouche.

C'est pourquoi on a aussi cherché à réaliser un capteur ayant une puce à quatre coins coupés, plus ergonomique à la fois pour l'introduction dans la bouche et pour le retrait. Mais on ne dispose alors plus de la place nécessaire pour placer un registre de lecture au bas de la matrice.

Une solution à ce problème a été proposée dans le brevet US 5 510 623. Elle consiste à placer un registre de lecture non pas horizontalement au bas de la matrice mais verticalement au milieu de la matrice comme cela est représenté sur la figure 2.

Dans ce cas, les charges sont déversées horizontalement depuis les deux demi-matrices gauche et droite vers le registre vertical central, puis elles sont évacuées par le registre vertical vers une sortie centrale située au bas du capteur. L'ergonomie du capteur est optimisée grâce aux quatre coins coupés, mais l'image est perturbée dans la zone centrale du capteur à cause de la présence du registre vertical, même si le registre vertical est lui-même photosensible.

L'invention propose une solution pour bénéficier au mieux des avantages ergonomiques d'une puce à quatre coins coupés sans perturber la prise de vue au centre de la matrice.

A cet effet, l'invention propose un capteur d'image comprenant une matrice de lignes et colonnes de points photosensibles réalisée sur une puce de forme générale carrée ou rectangulaire à pans coupés, caractérisé en ce qu'il comporte un registre de lecture placé au bas de la matrice, ce registre étant coudé pour longer les pans coupés de la puce et comportant de ce fait une partie horizontale et deux parties obliques, et le capteur comportant en outre des moyens pour diriger des charges photosensibles de colonnes aboutissant en regard des pans coupés vers des étages de registre situés dans les parties obliques le long des pans coupés.

Les moyens pour diriger les charges vers la partie oblique du registre incluent notamment des zones d'isolation entre colonnes de la matrice, ces zones étant coudées pour aider au transfert de charges vers la partie oblique du registre. D'autre part, certaines des électrodes de ligne qui servent au transfert de charges dans le sens vertical, et qui s'étendent linéairement en forme de ruban horizontal le long de la matrice, sont de préférence coudées à leur extrémité pour qu'au croisement d'une extrémité de ligne et une extrémité de colonne à proximité immédiate de la partie oblique du registre, l'extrémité de la dernière électrode comporte une partie s'étendant parallèllement à la partie oblique du registre. Les électrodes qui précèdent immédiatement cette dernière électrode ont des formes intermédiaires entre un ruban horizontal et le ruban coudé constituant l'extrémité de la dernière électrode pour faciliter le transfert de charges vers la partie oblique du registre.

Le registre de lecture peut avoir une sortie située à droite ou à gauche. Mais il a de préférence une sortie centrale, c'est-à-dire qu'il est divisé en deux demi-registres fonctionnant dans des sens opposés pour ramener les charges de la moitié gauche de la matrice vers la droite et les charges de la moitié droite vers la gauche. Le registre peut dans ce cas avoir soit deux sorties centrales côte à côte, une pour chaque demi-registre, soit une seule sortie centrale, les charges des deux demi-registres se déversant en alternance vers un même circuit de lecture qui multiplexe les signaux issus des deux demi-registres.

La présence d'un registre le long d'un pan coupé dans une structure matricielle modifie l'ordre de succession des signaux extraits de la matrice, et impose de rétablir cet ordre lors de l'exploitation des signaux pour la reconstitution d'une image globale. Des moyens de reconstitution de l'ordre des points d'image, en fonction de la configuration exacte des pans coupés et du registre qui suit leur contour, doivent donc être prévus, soit sur le capteur lui-même (sur la puce) soit en dehors du capteur.

D'autres caractéristiques et avantages de l'invention apparaîtront à la lecture de la description détaillée qui suit et qui est faite en référence aux dessins annexés dans lesquels :
- la figure 1, déjà mentionnée, représente un capteur d'image dentaire dont la puce comporte deux coins coupés ;
- la figure 2, également déjà mentionnée, représente un capteur dont la puce comporte quatre coins coupés.
- la figure 3 représente le principe d'un capteur selon l'invention, avec une sortie latérale du registre de lecture "horizontal" ;
- la figure 4 représente un capteur avec deux sorties centrales ;
- la figure 5 représente un capteur avec une seule sortie centrale multiplexée ;
- la figure 6 représente la forme de principe des électrodes permettant un déversement des charges dans le registre de sortie au niveau des pans coupés ;
- la figure 7 représente un détail de réalisation dans le cas où les colonnes de la matrice fonctionnent en registre à transfert de charges à quatre électrodes par étage de registre ;
- la figure 8 représente les conducteurs métalliques destinés à amener les signaux de commande aux différentes électrodes de ligne de la matrice de la figure 7.
   L'invention sera décrite à propos d'un capteur radiologique dentaire intraoral bien qu'elle soit applicable à d'autres cas où des problèmes analogues d'encombrement, de confort et d'ergonomie se poseraient.

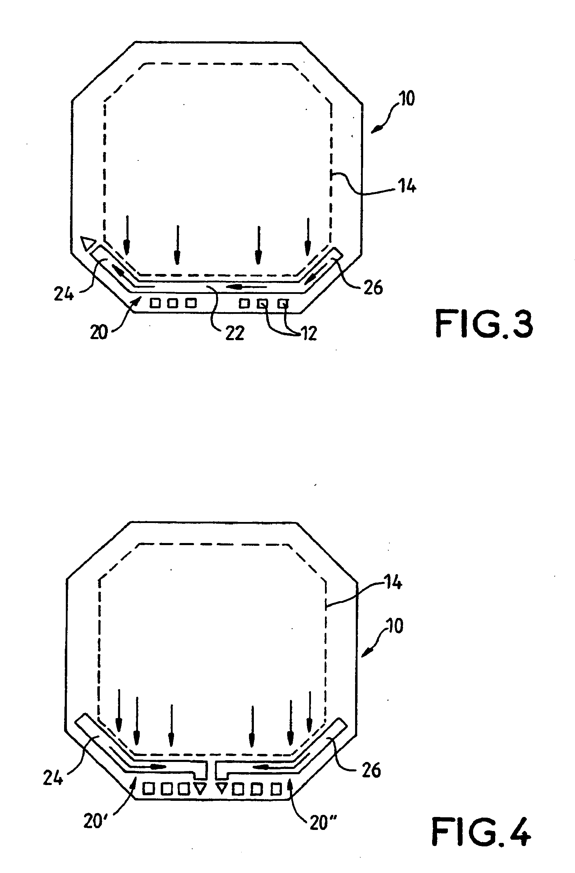

   La figure 3 représente une puce électronique 10 selon l'invention, destinée à être encapsulée dans un boîtier épousant sensiblement la forme de la puce ; la puce électronique comprend quatre côtés principaux, haut, bas, droite, gauche, qui sont perpendiculaires deux à deux, et elle présente quatre pans coupés qui interrompent les côtés principaux avant qu'ils ne se croisent. La puce sera montée sur une embase non représentée, de même forme rectangulaire à quatre pans coupés, et elle sera reliée à cette embase par des fils de liaison ("wire-bonding") internes au boîtier et soudés d'un côté sur l'embase et de l'autre sur des plots de connexion 12 prévus sur la puce. L'ensemble de la puce et de l'embase est enfermé dans un boîtier étanche non représenté qui épouse la forme rectangulaire à pans coupés de la puce et de l'embase et qui a de préférence des angles arrondis pour le confort et l'ergonomie. Des fils de connexion vers l'extérieur, reliés à l'embase, sortent de ce boîtier, d'un seul côté qui est de préférence mais non obligatoirement le côté bas de la figure, de sorte qu'un seul faisceau de fils, non représenté, situé en bas du capteur, part du capteur pour être relié à un appareil extérieur ; ces fils servent à l'alimentation électrique du capteur et au recueil des signaux électriques représentant l'image détectée par le capteur ; pour un capteur intraoral, ce faisceau de fils sort de la bouche du patient lors de la prise de vue radiologique de l'intérieur de la bouche ; le côté haut de la figure est le côté amont dans le sens d'introduction du capteur dans la bouche d'un patient.
   Le capteur est un capteur matriciel constitué d'un réseau de lignes et de colonnes de points photosensibles, chaque point photosensible recueillant des charges électriques en proportion de l'exposition de ce point à la lumière. La zone active proprement dite, comprenant ces points photosensibles, est une zone 14, de forme rectangulaire à pans coupés comme la forme de la puce, représentée ici par son périmètre en traits tiretés. Autour de cette zone sont logés les circuits électroniques nécessaires au fonctionnement de la matrice, et notamment les registres de commande de lignes. La zone active comprend donc un côté bas, un côté haut, un côté droit, un côté gauche, qui sont les quatre côtés qu'on peut appeler rectangulaires, et elle comprend aussi un pan coupé bas-gauche, un pan coupé bas-droite, un pan coupé haut-gauche, et un pan coupé haut-droit.
   Les angles de pans coupés dépendent du rapport entre le pas des lignes et le pas des colonnes de la matrice. De préférence, le pas est le même en ligne et en colonne (par exemple 20 micromètres) et les pans coupés sont alors à 45° ce qui est le plus facile à réaliser.
   Les charges électriques recueillies par les points photosensibles sont transférées verticalement en colonne vers le bas de la matrice où elles se déversent dans un registre de lecture (qu'on appelera registre "horizontal" par analogie avec les registres de lecture habituels qui sont disposés horizontalement au bas de la matrice) ; le déversement est fait selon un procédé classique consistant
- à transférer les charges verticalement d'une ligne à la suivante, simultanément pour toutes les lignes de la matrice, la dernière ligne étant transférée dans le registre horizontal,
- à lire la ligne contenue dans le registre de lecture,
- à effectuer un nouveau pas de transfert vertical, et ainsi de suite.

Selon l'invention, le registre de lecture 20 dit "horizontal", qui transfère vers une sortie les charges qu'il a reçues après un pas de décalage vertical de la matrice, longe les deux pans coupés du bas de la matrice. Le registre comporte donc une partie horizontale 22 le long du côté bas de la zone active, et deux parties obliques 24 et 26, respectivement le long du côté bas-gauche et le long du côté bas-droit de la zone active. Cela pose bien sûr des problèmes techniques que l'on détaillera ci-après. Les charges des différentes colonnes sont déversées non seulement dans la partie horizontale 22 du registre, le long du côté bas de la puce, mais aussi directement depuis les colonnes de la matrice vers les parties obliques 24 et 26 du registre.

Dans une première réalisation, représentée à la figure 3, le registre de lecture comporte une seule sortie située à l'extrémité distale (la plus éloignée de la partie horizontale 22) de la partie oblique 24 (ou 26) du registre.

Dans une deuxième réalisation, représentée à la figure 4, il y a deux demi-registres 20' et 20", l'un à gauche, l'autre à droite ; chaque demi-registre comprend une moitié de la partie horizontale et une partie oblique respective, gauche pour le demi-registre 20', droite pour le demi-registre 20". Les demi-registres peuvent avoir des sorties aux extrémités des parties obliques, dans une configuration proche de celle de la figure 3 mais avec deux sorties symétriques. Mais ils peuvent aussi avoir des sorties côte à côte, aux extrémités adjacentes des moitiés de parties horizontales des registres, donc au centre du côté bas de la matrice, comme cela est représenté sur la figure 4.

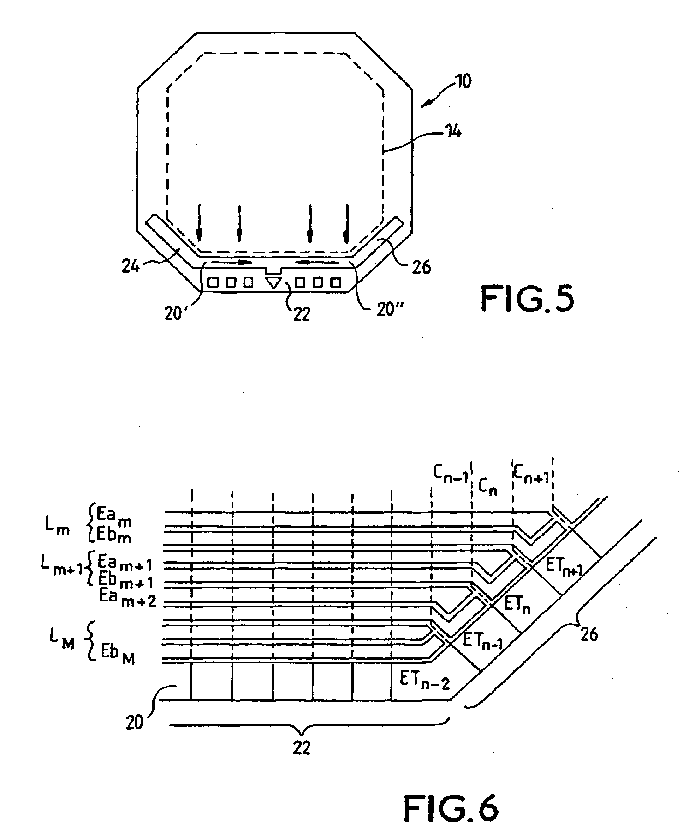

Dans une troisième réalisation, représentée à la figure 5, les deux demi-registres 20' et 20" ont une seule sortie au centre du côté bas de la matrice, et cette sortie fournit alternativement, de manière multiplexée, les charges provenant du côté gauche et du côté droit de la matrice de points photosensibles. Il faut ensuite démultiplexer les signaux pour reconstituer une ligne d'image.

La première réalisation permet un dessin simple du registre et simplifie la conception de la commande du registre. Mais elle ne permet pas d'optimiser l'utilisation de la zone de puce disponible entre le bord gauche (ou droit) de la zone active et le bord gauche (ou droit) de la puce.

La deuxième réalisation permet de rapprocher le bord de la zone active du bord gauche ou droit de la puce, donc d'augmenter la surface de la zone de prise d'image pour une même surface de puce, mais elle oblige à compliquer le dessin de la sortie des registres. De plus, l'existence de deux sorties implique un risque de déséquilibre entre la moitié gauche et la moitié droite de l'image. Et la consommation des sorties est plus importante.

La troisième réalisation permet aussi de rapprocher le bord de la zone active du bord de la puce. Le dessin de la sortie est plus simple que dans la deuxième solution. Cette troisième solution permet d'optimiser les dimensions de la puce, de s'affranchir de certaines dispersions de gain entre sorties distinctes, et de minimiser la consommation grâce à l'utilisation d'un seul amplificateur de lecture.

La figure 6 représente un dessin schématique d'électrodes permettant de déverser efficacement les charges dans un registre coudé à partir de colonnes qui n'arrivent pas perpendiculairement au registre dans les parties obliques de celui-ci.

Le registre de lecture 20 est représenté dans sa partie située à l'angle entre la partie horizontale 22 et la partie oblique 26 du registre.

La matrice de la zone active a des lignes horizontales Lₘ, Lₘ₊₁, pour les lignes de rang m et m+1 respectivement, etc., et pour simplifier les explications on a supposé, dans le cas de la figure 6, que chaque ligne comporte deux électrodes seulement: une électrode Ea de type a, une électrode Eb de type b (électrodes Eaₘ, Ebₘ pour la ligne de rang m, Eaₘ₊₁, Ebₘ₊₁ pour une ligne suivante). Les électrodes sont toutes étroitement adjacentes les unes aux les autres pour assurer les transferts de charge. On suppose aussi pour simplifier que la dernière électrode Eb_{M} de la dernière ligne de la matrice, c'est-à-dire la ligne de rang M, la plus proche du registre de lecture, est immédiatement adjacente au registre de lecture.

La matrice a également des colonnes verticales Cₙ , Cₙ₊₁ , etc., isolées entre elles (typiquement par des diffusions de type P lorsque les zones superficielles de stockage et de transfert de charge sont de type N) pour éviter un transfert latéral de charges, ces colonnes se comportant, grâce aux électrodes de ligne, comme des registres à décalage verticaux, c'est-à-dire que pendant une phase de lecture de l'image stockée dans la matrice sous forme de charges électriques, les charges des pixels d'une colonne, sont décalées verticalement ligne par ligne dans cette colonne et les charges de la dernière ligne sont déversées à l'extrémité de la colonne.

Alors que sur l'ensemble d'une matrice classique les électrodes de ligne sont des conducteurs en forme de ruban rectiligne horizontal sur toute la longueur de la matrice, avec une électrode de type b unique (Eb_{M}) adjacente à un registre horizontal sur toute sa longueur et une électrode unique de type a (Ea_{M}) adjacente sur toute sa longueur à l'électrode Eb_{M}, on voit qu'il faut ici adopter une conformation spéciale d'électrodes de type a et de type b ou une conformation spéciale du registre de lecture pour qu'une succession de deux électrodes de type a puis b soit adjacente au registre même dans la partie oblique du registre.

Le registre de lecture pourrait remonter en escalier le long du bord oblique de la zone matricielle ; cette configuration en escalier aurait l'avantage de permettre que les électrodes de type a et de type b pourraient rester théoriquement rectilignes sur toute leur longueur y compris à leur extrémité adjacente à la partie oblique 26 du registre de lecture. Cependant, une configuration en escalier du registre de lecture est moins efficace pour le transfert de charges.

Sur la figure 6, on a choisi de donner au registre, dans sa partie oblique 26 une configuration rectiligne et non en escalier. On donne alors aux extrémités d'électrodes de ligne qui aboutissent au registre une configuration particulière. D'autre part, on aide le transfert vertical de charges vers le registre en faisant tourner les colonnes vers le registre. Ceci est fait en coudant perpendiculairement au registre les zones d'isolation qui séparent les colonnes entre elles (ces zones d'isolation sont symbolisées par les lignes pointillées sur la figure 6).

On suppose, sur la figure 6, que la colonne Cₙ de rang n aboutit sur le registre à l'endroit où la ligne Lₘ₊₁ de rang m+1 aboutit sur le registre. C'est-à-dire que c'est la ligne Lₘ₊₁ qui constitue la dernière ligne dans laquelle seront transférées les charges de la colonne Cₙ av ant que ces charges ne soient déversées dans le registre ; et ces charges seront alors transférées dans un étage ETₙ du registre, dédié à la colonne Cₙ. Plus précisément, c'est l'électrode Ebₘ₊₁ qui constitue la dernière électrode dans la colonne Cₙ; l'électrode Eaₘ₊₁ constitue l'avant-dernière électrode.

On s'intéressera uniquement aux colonnes de la demi-matrice de droite, étant entendu que la demi-matrice de gauche est généralement symétrique de la demi-matrice de droite.

L'électrode Ebₘ₊₁ de la ligne Lₘ₊₁ est rectiligne et parallèle à la partie horizontale 22 du registre de lecture, sauf à son extrémité ; c'est-à-dire que cette électrode est rectiligne et horizontale lorsqu'elle croise les colonnes successives jusqu'au rang n-1, mais elle cesse d'être rectiligne, dans la configuration de la figure 6, lorsqu'elle croise la colonne de rang n.

A cet endroit, l'extrémité de l'électrode Ebₘ₊₁ de la ligne Lₘ₊₁ est coudée de manière qu'une partie de l'électrode vienne s'étendre parallèlement à l'étage ETₙ du registre oblique 26. Le coude est d'abord un coude vers le bas, perpendiculaire à la partie oblique du registre, puis un coude vers le haut parallèle au registre.

De la même manière, l'électrode Eaₘ₊₁ est en forme de ruban rectiligne tant qu'elle croise les colonnes de la matrice jusqu'à la colonne de rang n-1 ; mais à l'endroit où elle croise la colonne de rang n, elle prend une autre forme, telle qu'elle reste étroitement adjacente à la fois à l'électrode rectiligne qui la précède immédiatement (ici : Ebₘ) d'un côté et à l'électrode coudée Ebₘ₊₁ de l'autre côté.

Dans le sens du décalage de charges dans les zones obliques du registre de lecture, le pas des étages du registre est augmenté d'autant plus que l'inclinaison du pan coupé est forte. Pour un pan coupé à 45°, le pas est augmenté dans le rapport racine carré de 2. Le registre horizontal est lui-même composé d'une succession d'électrodes adjacentes les unes aux autres (par exemple deux ou quatre électrodes par étage du registre) ; ces électrodes ne sont pas représentées sur la figure 6 ; elles sont plus larges dans la partie oblique 26 du registre, là où le pas des registres est plus large, que dans la partie horizontale 22.

L'étage de registre constituant la transition où le registre passe d'une configuration horizontale à une configuration oblique, ici l'étage référencé ETₙ₋₂ peut être plus grand que les autres étages (en longueur dans le sens de circulation des charges dans le registre) comme c'est représenté sur la figure 6. Toutefois, Il peut être préférable de le couper en plusieurs éléments, par exemple en deux demi-étages, le transfert de charges dans le registre étant moins bon si les électrodes de registre sont trop larges (largeur dans le sens de circulation des charges). Cependant, si l'étage ETₙ₋₂ est coupé en deux, on comprendra que seul un des deux demi-étages doit recevoir des charges de la colonne (ici la colonne Cₙ₋₂) qui débouche en regard de l'étage ETₙ₋₂. Une barrière d'isolation (diffusion p+ par exemple) est donc placée devant l'autre demi-étage pour le séparer des colonnes adjacentes (Cₙ₋₂ autant que Cₙ₋₁). Ce demi-étage ne recevant pas de charges des colonnes, on doit en tenir compte lors de l'exploitation du signal en sortie du registre horizontal : un "trou" sera présent dans la série de valeurs de pixels issue du registre, ce trou correspondant à un emplacement virtuel entre les colonnes Cₙ₋₂ et Cₙ₋₁. SI les étages de registre horizontaux comportent deux électrodes, les deux demi-étages constituant l'étage ETₙ₋₂ comportent aussi deux électrodes chacun.

Sur la figure 6, pour la facilité de l'explication, on a représenté des extrémités d'électrodes de type b indépendantes les unes des autres. Cependant, dans un registre à transfert de charges en colonne, toutes les électrodes de type a sont commandées simultanément et toutes les électrodes b sont commandées simultanément. La disposition de la figure 6 peut permettre de relier les électrodes de type b les unes avec les autres en formant une seule électrode continue le long de la partie oblique du registre puisqu'elles sont pratiquement adjacentes les unes aux autres là où elles longent cette partie oblique. Ce n'est pas le cas des électrodes de type a qui restent séparées physiquement les unes des autres mais qui doivent être reliées électriquement entre elles par d'autres moyens qu'on détaillera plus loin.

Avec un registre ainsi configuré avec une partie horizontale et une partie oblique, il se pose un problème d'exploitation des signaux recueillis par le registre de lecture. En effet, alors que classiquement le registre de lecture déverse à chaque fois vers une sortie les signaux correspondant à une ligne d'image, on a ici un mélange d'informations entre lignes différentes.

Si on appelle S_{m,n} le signal recueilli dans le point photosensible au croisement d'une ligne de rang m et d'une colonne de rang n, un registre de lecture classique fournirait successivement dans l'ordre les signaux suivants, en supposant qu'on ne s'intéresse qu'à la moitié droite de la matrice (colonnes 1 à N) et que la sortie du registre se fait vers la droite :
- S_{M,1}, S_{M,2},.....S_{M,N}
- puis S_{M}-_{1,1}, S_{M-1,2}, .....S_{M-1,N}
- puis S_{M}-_{2,1,} S_{M}-₂,_{2,} .....S_{M-2,N}
etc.

Mais dans l'invention, l'ordre des signaux est bouleversé, les informations transmises étant successivement :
- d'abord les informations S_{M,1}, S_{M,2}, ... de la ligne L_{M} dans l'ordre des colonnes pour toutes les colonnes qui sont en regard de la partie horizontale du registre, puis S_{M,n-2}, S_{M-1,n-1}, S_{M-2,n}, etc. si on suppose que c'est à partir de la colonne n-1 que commence la partie oblique du registre,
- puis les informations S_{M-1,1}, S_{M-1,2}, ...... de la ligne L_{M-1} dans l'ordre des colonnes pour toutes les colonnes qui sont en regard de la partie horizontale du registre, puis S_{M-1,n-2}, S_{M-2,n-1}, S_{M-3,n}, etc.
- et ainsi de suite.

On prévoit donc, dans le capteur ou de préférence à l'extérieur du capteur, des moyens (en principe une mémoire tampon) pour réorganiser l'ordre des signaux pour permettre la reconstitution de l'image.

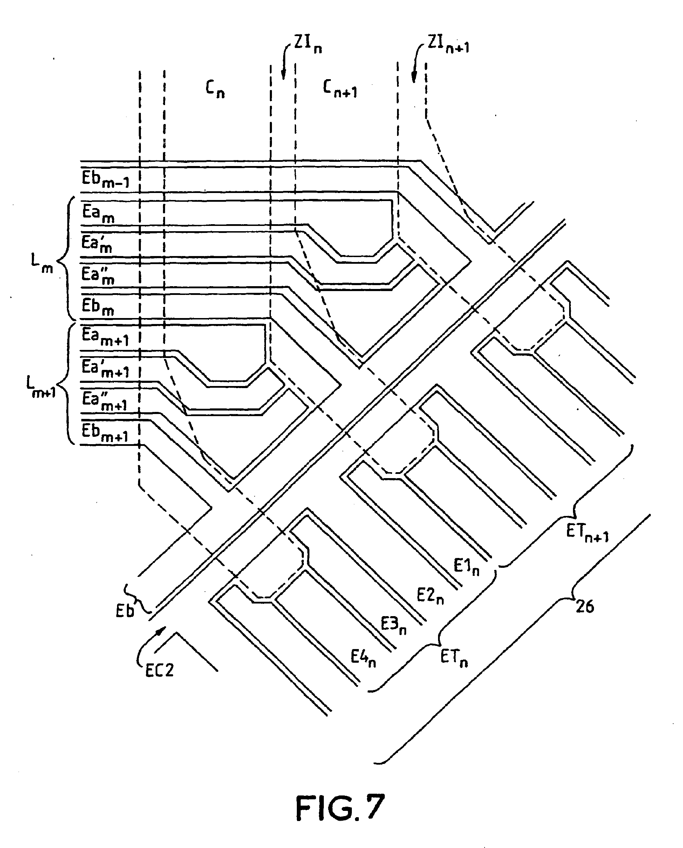

La figure 7 représente un exemple de réalisation pratique dans le cas le plus général où chaque ligne de matrice comporte quatre électrodes adjacentes commandées par des signaux permettant le décalage progressif de charges d'une ligne à la suivante. Dans cet exemple, le registre de lecture comporte également quatre électrodes par étage de registre. Seule une portion de partie oblique 26 du registre de lecture est représentée, avec l'intersection de deux lignes Lₘ, et Lₘ₊₁ et de deux colonnes Cₙ et Cₙ₊₁.

Chaque ligne comporte quatre électrodes, Eaₘ, Ea'ₘ, Ea"ₘ, et Ebₘ pour la ligne Lₘ. Les colonnes sont délimitées par des zones d'isolation Zlₙ, Zlₙ₊₁, qui canalisent les charges verticalement à l'intérieur d'une colonne et qui sont coudées à leur extrémité perpendiculairement au registre pour canaliser les charges obliquement vers un étage respectif ETₙ, ETₙ₊₁ du registre de lecture. L'extrémité de colonne dans laquelle passent les charges transférées est donc coudée perpendiculairement au registre oblique.

Là où une colonne et une ligne se terminent en regard d'un étage de la partie oblique du registre de lecture, les quatre électrodes sont déformées et cessent d'être constituées d'un simple ruban rectiligne de largeur constante :
- l'électrode Ebₘ, qui est un ruban rectiligne tant qu'elle n'arrive pas devant la dernière colonne de rang n+1 est coudée obliquement vers le bas (au dessus de la zone d'isolation Zlₙ) puis obliquement vers le haut au dessus de la colonne Cₙ₊₁, le coude vers le haut constituant une portion d'électrode qui longe le registre oblique ; toutes les électrodes Ebₘ sont de préférence attachées les unes aux autres sous forme d'un seul conducteur oblique Eb qui longe le registre oblique et qui regroupe toutes les parties coudées obliquement vers le haut des électrodes Ebₘ ;
- les électrodes Eaₘ, Ea'ₘ, Ea"ₘ ont des formes intermédiaires permettant de passer progressivement de la forme de ruban rectiligne horizontal de largeur constante que possède l'électrode Ebₘ₋₁ dans la colonne Cₙ₊₁ à la forme de ruban oblique de l'électrode Ebₘ dans cette même colonne.

Dans cette réalisation on a fait en sorte que les électrodes de la ligne Lₘ cessent d'être en forme de ruban rectiligne seulement lorsqu'elles arrivent dans la dernière colonne Cₙ₊₁ mais on pourrait envisager que la déformation des électrodes commence un peu avant, par exemple lorsqu'elles sont encore dans l'avant dernière colonne Cₙ, pour faciliter, à l'intérieur de cette colonne, la progressivité de déformation des électrodes d'une forme en ruban horizontal a une forme en ruban oblique.

Le registre de lecture a dans cet exemple quatre électrodes par étage, E1_{n,} E2ₙ, E3ₙ, E4ₙ pour l'étage ETₙ. Les charges en provenance de la colonne de rang n se déversent sous l'électrode E2ₙ lorsque celle-ci est à un potentiel approprié ; toutes les électrodes E2ₙ, E2ₙ₊₁, etc. sont réunies ensemble par un conducteur EC2 s'étendant le long du registre de lecture parallèlement au conducteur Eb.

Dans une matrice classique, les signaux de commande des électrodes de ligne seraient appportés par les extrémités de ces électrodes sur un côté de la matrice. Mais dans la matrice selon l'invention il y a une difficulté car les extrémités des électrodes ne sont pas accessibles facilement sur le côté de la matrice, là où ces électrodes aboutissent devant la partie oblique du registre ; et ceci ni à droite ni à gauche.

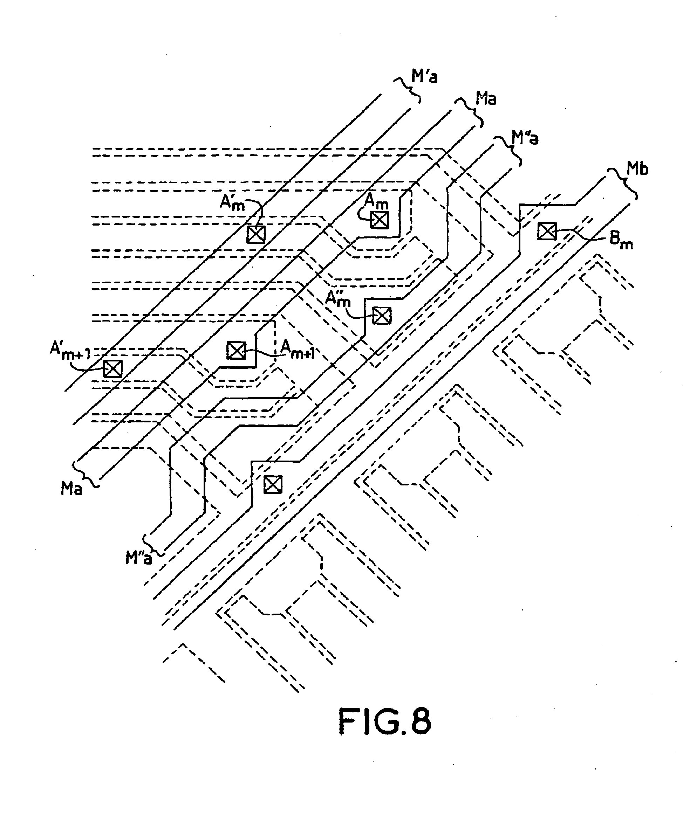

C'est pourquoi on prévoit que des métallisations d'accès à ces électrodes passent le long du registre oblique, au dessus des électrodes, et viennent en contact ponctuellement avec les électrodes qu'il faut alimenter. Dans le registre à quatre électrodes par ligne de la figure 7, on prévoit de préférence quatre lignes de métallisation Ma, Ma', Ma", Mb, qui courent le long du registre oblique pour venir en contact respectivement avec les électrodes Ea, les électrodes Ea', les électrodes Ea", et les électrodes Eb. Ces lignes sont représentées sur la figure 8.

Ces métallisations (de préférence en aluminium) doivent occuper le moins de place possible car elles masquent les zones photosensibles situées le long du registre de lecture. On peut faire en sorte qu'elles ne masquent au total qu'une ou deux lignes de points photosensibles.

La figure 8, superposable à la figure 7, montre les lignes de métallisation qu'on peut prévoir, et les zones où elles contactent les électrodes de ligne pour leur appliquer les signaux de commande voulus. Les électrodes mentionnées en référence à la figure 7 sont représentées en pointillés sur la figure 8. Les conducteurs métalliques qui leur apportent les signaux de commande sont représentés en traits pleins. Les zones de contact entre un conducteur métallique et une électrode située au dessous (et isolée par une couche d'isolant interrompue à l'endroit des contacts) sont représentées par un carré barré d'une croix. Le dessin des conducteurs est tel qu'on respecte à la fois une largeur suffisante des conducteurs (pour assurer une conductivité suffisante), une largeur suffisante à l'endroit des contacts (pour éviter les défauts de conctact) et un intervalle suffisant entre conducteurs (pour éviter les défauts de court-circuit).

La métallisation Ma contacte ponctuellement les électrodes Eaₘ, Eaₘ₊₁, etc., en des points Aₘ, Aₘ₊₁, etc.

La métallisation Ma' contacte ponctuellement les électrodes Ea'ₘ, Ea'ₘ₊₁, etc., en des points A'ₘ, A'ₘ₊₁, etc.

La métallisation Ma" contacte ponctuellement les électrodes de rang pair Ea"ₘ, Ea"ₘ₊₂, etc. mais pas les électrodes de rang impair Ea"ₘ₊₁, s'il n'y a pas suffisamment de place (mais on pourrait éventuellement créer plus de place en écartant les conducteurs Ma, Ma', Ma", Mb les uns des autres ou en utilisant une configuration différente). Si le contact n'est pas fait avec les électrodes de rang impair, il faut bien entendu prévoir un contact avec ces électrodes à un autre endroit, et cet autre endroit est tout simplement l'autre côté de la matrice (côté gauche) ; en effet, les conducteurs Ma, Ma', Ma", Mb s'étendant tout le long du registre de lecture aussi bien dans sa partie horizontale que dans ses deux parties obliques.

Enfin, la métallisation Mb contacte de place en place, en des points Bₘ l'électrode commune Eb qui est reliée, on le rappelle, aux électrodes Ebₘ, Ebₘ₊₁, etc. Il n'est pas nécessaire de prévoir un contact ayant la même périodicité que le pas des lignes. Dans l'exemple représenté un contact est fait une ligne sur deux.

Le capteur matriciel ainsi réalisé est recouvert d'une couche scintillatrice avant encapsulation si on veut réaliser un capteur radiologique, et notamment pour réaliser un capteur radiologique dentaire intraoral.

## Revendications

1. Capteur d'image comprenant une matrice (14) de lignes et colonnes de points photosensibles réalisée sur une puce (10) de forme générale carrée ou rectangulaire à pans coupés, comportant un registre de lecture (20) placé au bas de la matrice, **caractérisé en ce que** ce registre est coudé pour longer les pans coupés de la puce et comporte de ce fait une partie horizontale (22) et deux parties obliques (24, 26), le capteur comportant en outre des moyens (Zlₙ) pour diriger des charges photosensibles de colonnes aboutissant en regard des pans coupés vers des étages de registre situés dans les parties obliques le long des pans coupés.

2. Capteur d'image selon la revendication 1, **caractérisé en ce que** les moyens pour diriger les charges comprennent des zones d'isolation (Zlₙ, Zlₙ₊₁, ...) entre colonnes, ces zones étant coudées pour faciliter le transfert de charges en provenance des colonnes vers le registre.

3. Capteur d'image selon l'une des revendications 1 et 2, **caractérisé en ce que** chaque ligne de la matrice comporte plusieurs électrodes (Eaₘ, Ea'ₘ, Ea"ₘ, Ebₘ...) s'étendant en ruban linéaire et **en ce que** les extrémités de certaines de ces électrodes sont coudées pour que, à l'intérieur d'une colonne (Cₙ₋₁) aboutissant sur une partie oblique du registre, la dernière électrode (Ebₘ) de la dernière ligne de cette colonne s'étende parallèllement au pan coupé, les électrodes (Ea"ₘ, Ea'ₘ, Eaₘ) qui précèdent cette électrode ayant des formes intermédiaires entre une forme de ruban oblique et une forme de ruban horizontal de manière à faciliter la transmission de charges sous ces électrodes de la colonne vers le registre.

4. Capteur d'image selon la revendication 3, **caractérisé en ce que** la dernière électrode (Eb) de la dernière ligne de la matrice s'étend continûment le long de la partie horizontale et des parties obliques du registre.

5. Capteur d'image selon l'une des revendications 1 à 3, **caractérisé en ce qu'**il comporte plusieurs conducteurs métalliques (Ma, Ma', Ma", Mb) s'étendant le long du registre et venant en contact localement avec les différentes électrodes de transfert de charges constituant les lignes de la matrice.

6. Capteur d'image selon l'une des revendications précédentes, **caractérisé en ce que** le registre de lecture possède une sortie centrale, c'est-à-dire qu'il est divisé en deux demi-registres fonctionnant dans des sens opposés pour ramener les charges de la moitié gauche de la matrice vers la droite et les charges de la moitié droite vers la gauche.

7. Capteur d'image selon l'une des revendications précédentes, **caractérisé en ce que** la puce est recouverte d'un scintillateur.

8. Application du capteur selon la revendication 7 à la prise d'image radiologique dentaire intraorale.

## Claims

1. Image sensor comprising a matrix (14) of rows and columns of photosensitive dots, made on a chip (10) of general square or rectangular shape with beveled corners, comprising a reading register (20) placed at the bottom of the matrix, **characterized in that** the reading register (20) is bent so as to run alongside the beveled corners of the chip and therefore comprises a horizontal part (22) and two oblique parts (24, 26), the sensor furthermore comprising means (ZIₙ) for directing photosensitive charges of columns terminating opposite the beveled corners to register stages situated in the oblique parts alongside the beveled corners.

2. Image sensor according to Claim 1, **characterized in that** the means for directing the charges comprise insulation zones (ZIₙ, ZIₙ₊₁, etc.) between columns, these zones being bent so as to facilitate the transfer of charges originating from the columns to the register.

3. Image sensor according to one of Claims 1 and 2, **characterized in that** each row of the matrix comprises several electrodes (Eaₘ, Ea'ₘ, Ea"ₘ, Ebₘ, etc.) extending in a linear strip and **in that** the ends of certain of these electrodes are bent so that, inside a column (Cₙ₋₁) terminating on an oblique part of the register, the last electrode (Ebₘ) of the last row of this column extends parallel to the beveled corner, the electrodes (Ea"ₘ, Ea'ₘ, Eaₘ) which precede this electrode having shapes intermediate between an oblique strip shape and a horizontal strip shape so as to facilitate the transmission of charges under these electrodes from the column to the register.

4. Image sensor according to Claim 3, **characterized in that** the last electrode (Eb) of the last row of the matrix extends continuously along the horizontal part and the oblique parts of the register.

5. Image sensor according to one of Claims 1 to 3, **characterized in that** it comprises several metallic conductors (Ma, Ma', Ma", Mb) extending along the register and coming into contact locally with the various charge transfer electrodes constituting the rows of the matrix.

6. Image sensor according to one of the preceding claims, **characterized in that** the reading register possesses a central output, that is to say it is divided into two half-registers operating in opposite senses so as to bring the charges from the left half of the matrix to the right and the charges from the right half to the left.

7. Image sensor according to one of the preceding claims, **characterized in that** the chip is covered with a scintillator.

8. Application of the sensor according to Claim 7 to intraoral dental radiological image capture.

## Patentansprüche

1. Bildsensor, der eine Matrix (14) aus Zeilen und Spalten lichtempfindlicher Punkte aufweist, die auf einem Chip (10) mit allgemein quadratischer oder rechteckiger Form mit schrägen Kanten hergestellt sind, der ein Leseregister (20) aufweist, das sich unten auf der Matrix befindet, **dadurch gekennzeichnet, dass** das Leseregister (20) abgewinkelt ist, und sich entlang der schrägen Kanten des Chips erstreckt und daher einen horizontalen Teil (22) und zwei schräge Teile (24, 26) aufweist, wobei der Sensor ferner Mittel (ZIₙ) aufweist, um lichtempfindliche Ladungen von Spalten, die gegenüber schrägen Kanten enden, zu Registerstufen zu lenken, die sich in den schrägen Teilen entlang der schrägen Kanten befinden.

2. Bildsensor nach Anspruch 1, **dadurch gekennzeichnet, dass** die Mittel zum Lenken der Ladungen Isolierzonen (ZIₙ, ZIₙ₊₁,...) zwischen Spalten aufweisen, wobei diese Zonen abgewinkelt sind, um den Transfer von Ladungen, die von den Spalten kommen, zu dem Register zu erleichtern.

3. Bildsensor nach einem der Ansprüche 1 und 2, **dadurch gekennzeichnet, dass** jede Zeile der Matrix mehrere Elektroden (Eaₘ, Ea'ₘ, Ea"ₘ, Ebₘ, ...) aufweist, die sich in einem linearen Band erstrecken, und dass die Enden bestimmter dieser Elektroden abgewinkelt sind, damit sich im Inneren einer Spalte (Cₙ₋₁), die auf einem schrägen Teil des Registers endet, die letzte Elektrode (Ebₘ) der letzten Zeile dieser Spalte parallel zu der schrägen Kante erstreckt, wobei die Elektroden (Ea"ₘ, Ea'ₘ, Eaₘ), die dieser Elektrode vorausgehen, Zwischenformen zwischen einer Form eines schrägen Bands und einer Form eines horizontalen Bands derart haben, dass das Übertragen von Ladungen unter diesen Elektroden der Spalte zum Register erleichtert wird.

4. Bildsensor nach Anspruch 3, **dadurch gekennzeichnet, dass** sich die letzte Elektrode (Eb) der letzten Zeile der Matrix ununterbrochen entlang des horizontalen Teils und der schrägen Teile des Registers erstreckt.

5. Bildsensor nach einem der Ansprüche 1 bis 3, **dadurch gekennzeichnet, dass** er mehrere metallische Leiter (Ma, Ma', Ma", Mb) aufweist, die sich entlang des Registers erstrecken und lokal mit den verschiedenen Ladungstransferelektroden, die die Zeilen der Matrix bilden, in Berührung kommen.

6. Bildsensor nach einem der vorhergehenden Ansprüche, **dadurch gekennzeichnet, dass** das Leseregister einen zentralen Ausgang besitzt, das heißt, dass es in zwei Halbregister unterteilt ist, die in entgegengesetzte Richtungen funktionieren, um die Ladungen der linken Hälfte der Matrix zu der rechten und die Ladungen der rechten Hälfte zu der linken zurückzubringen.

7. Bildsensor nach einem der vorhergehenden Ansprüche, **dadurch gekennzeichnet, dass** der Chip mit einem Szintillator abgedeckt ist.

8. Anwendung des Sensors nach Anspruch 7 auf das Aufnehmen intraoraler zahntechnischer Röntgenbilder.
